**Europäisches Patentamt**

**European Patent Office**

**Office européen des brevets**

(19)

(11) Publication number: **0 092 116**
**A1**

## (12) EUROPEAN PATENT APPLICATION

(21) Application number: **83103386.5**

(22) Date of filing: **07.04.83**

(51) Int. Cl.³: **H 03 K 5/08,** H 03 K 5/153,
G 01 P 3/48

(30) Priority: **20.04.82 US 370112**

(43) Date of publication of application: **26.10.83**
**Bulletin 83/43**

(84) Designated Contracting States: **DE FR GB IT**

(71) Applicant: **TRW INC, 23555 Euclid Avenue, Cleveland Ohio 44177 (US)**

(72) Inventor: **Witt, Paul A., 15410 Marilyn Street, Plymouth, Michigan 48170 (US)**

(74) Representative: **Leiser, Gottfried, Dipl.-Ing. et al, Patentanwälte Prinz, Bunke & Partner Ernsberger Strasse 19, D-8000 München 60 (DE)**

(54) Clipper circuit and signal comparator employing same.

(57) A clipper circuit (32) is disclosed which prevents an input signal level from going beyond a predetermined minimum (or maximum) level. The clipper circuit (32) has at least three terminals: a input terminal (36), an output terminal (38), and a reference terminal (40). It includes an impedance, such as a resistor (46), connected between the input and output terminals (36, 38), and a transistor (48). The base of the transistor (48) is connected to the input terminal (36), and the collector-emitter current path of the transistor (48) is connected between the output terminal (38) and the reference terminal (40). A reference potential (e.g., ground potential) representing the desired clipping level is applied to the reference terminal (40). When the input signal level is on one side of the reference potential, the transistor (48) is cut off and thus the input signal is transmitted to the output terminal (38) without change. When the input signal tends towards the other side of the reference potential, however, the transistor (48) turns on and saturates, thereby preventing the output signal from exceeding the reference potential. A zero crossing detector is disclosed which uses the clipper circuit (32) to protect the input of a comparator circuit which is operated from a single-voltage power supply.

CLIPPER CIRCUIT AND SIGNAL
COMPARATOR EMPLOYING SAME

Background and Field of the Invention

The present invention relates to a clipper circuit and a signal comparator employing the clipper circuit for input protection.

Clipper circuits are electronic circuits which automatically limit the instantaneous amplitude of an electrical signal to a predetermined maximum (or minimum) value. Various types of clipper circuits are disclosed in the patent to Ort, U.S. Patent No. 2,980,806. Clipper circuits are often employed to protect other electrical circuits whose operation might be undesirably affected by signal levels beyond the boundary established by the clipper. Clippers have been employed, for example, to protect one or both of the inputs of the signal comparator circuits used as zero crossing detectors. The patents to Martin, U.S. Patent No. 3,593,166 and Matouka, U.S. Patent No. 3,697,782 disclose zero crossing detectors employing clippers for protection of comparator circuits. These prior clipper circuits are not suitable for some applications, however, since they do not clip the input signal precisely at the desired boundary level. One example of an application where precise clipping of an input signal is required is where the comparator of a zero crossing detector is operated from a single-voltage power supply.

A comparator, when operated from a single supply, will normally have one of its power supply terminals grounded and the other power supply terminal connected to the positive terminal of the power supply. If the applied AC signal drops below ground potential, it is no longer within the power supply range of the comparator. The comparator may respond to this in an abnormal manner. If the comparator is a conventional integrated circuit such as the LM139 (manufactured by National Semiconductor Corporation of Santa Clara, California), for example, the negative input signal can and will produce parasitic action between the two comparator inputs which in turn causes the comparator output to switch to an erroneous level. Even relatively small negative excursions of the input signal (e.g., -.3 volts) can cause such action. Hence the input must be rather precisely clipped at ground potential. Conventional clipper designs cannot readily be adapted to provide precise clipping at ground potential.

-3-

0092116

## Summary of the Invention

The present invention provides a clipping circuit which provides precise clipping of the input signal at a reference potential such as ground whereby it may be used to provide input signal protection of a comparator operated from a single power supply.

The clipping apparatus has at least three terminals, including an input terminal upon which an input signal is to be applied, an output terminal and a reference terminal to which a reference voltage (e.g., ground potential) is to be applied. The apparatus includes an impedance connected between the input and output terminals and a bipolar junction transistor (BJT) having its base connected to the input terminal and its collector/emitter current path connected between the output terminal and the reference terminal.

Whenever the level of the input signal is on one side of the reference voltage level, the transistor is turned off and the input voltage is transmitted to the output terminal through the impedance. When the level of the input signal is on the other side of the reference voltage level, however, the transistor is turned on and saturated, whereby the output terminal is essentially directly connected to the reference terminal. The voltage appearing at the output terminal will therefore never go beyond the reference voltage.

## Brief Description of the Drawings

The foregoing and other objects and advantages of the present invention will become more readily apparent from the following detailed description, as taken in conjunction with the accompanying drawings, wherein:

Fig. 1 is a block diagram of a zero crossing detector in a tachometer signal processing system;

Fig. 2 is a series of waveforms useful in understanding the operation of the Fig. 1 circuitry;

Fig. 3 is a circuit schematic of one embodiment of a clipper circuit for use as an input protection circuit in Fig. 1; and

Fig. 4 is a circuit schematic of another, and presently preferred embodiment of a precision clipper circuit for use as an input protection circuit in Fig. 1.

## Detailed Description

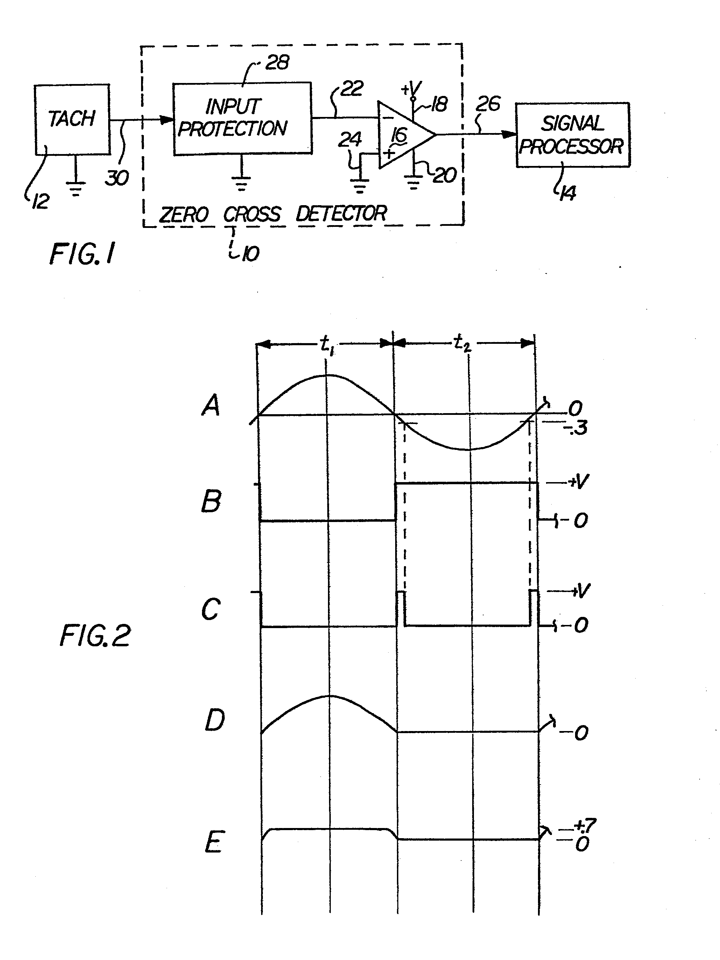

Fig. 1 illustrates a zero crossing detector 10 which transforms a bipolar signal provided by a tachometer 12 into a squarewave signal for application to a signal processing circuit 14. The tachometer 12 provides a bipolar output signal have a frequency corresponding to the speed of rotation of a mechanical part with which the tachometer 12 is associated. This bipolar signal is represented in Fig. 2A as, but is not restricted to, a sinusoid. During the first half cycle $t_1$ of the bipolar signal the output of the tachometer is above ground potential, whereas during the second half cycle $t_2$ the polarity of the tachometer output is reversed, i.e., the tachometer output signal is below ground potential.

The function of the zero crossing detector 10 is to convert the bipolar input signal into a bilevel, unipolar output signal suitable for application to the signal processing circuit 14. The desired form of the output signal, provided by the zero crossing detector in response to the bipolar input signal is shown in Fig. 2B. During the positive half cycle of the bipolar input signal the output of the zero crossing detector should be at ground potential, whereas during the negative half cycle of the bipolar input signal, the output should be at a fixed positive potential (+V). The output of the zero crossing detector should transition between the two possible output potentials (ground and +V) at each zero crossing, thus producing a unipolar square-wave time-correlate of the bipolar input signal.

To provide the desired switching between two output levels, the zero crossing detector 10 includes a comparator 16. The comparator 16 is a precision voltage comparator such as, for example, one of the four comparators included in an integrated circuit referred to as the LM139, manufactured by National Semiconductor Corporation of Santa Clara, California. The comparator 16 has two power supply terminals 18 and 20 across which a single DC voltage is preferably applied. The terminal 20 is grounded whereas the terminal 18 is connected to the +V output of a single-voltage, power supply.

The comparator 16 includes an inverting input terminal 22, a noninverting terminal 24, and an output terminal 26. The voltage appearing on the output terminal 26 will be one of two levels, depending upon the relative magnitudes of the input signals applied to the two input terminals 22 and 24. As a general rule, the output signal will be at a high logic level (+V) when the signal applied to the noninverting input terminal 24 is greater than the signal applied to the inverting input terminal 22. Similarly, the output will be at a low logic level (ground) when the signal applied to the inverting input terminal 22 is greater than the signal applied to the noninverting input terminal 24.

From the foregoing description of the usual operation of a comparator 16, it seems that the desired output signal could be provided by merely grounding the noninverting input terminal 24 and connecting the inverting input terminal 22 to the output of the tachometer 12. In such a case, one would expect that the output signal would be a squarewave signal having the form shown in Fig. 2B. Unfortunately, the signal of Fig. 2B is not produced. The reason is that the described operation of comparator 16 only holds true as long as the input signals are between the voltage levels applied to the two power supply terminals 18 and 20. If one of the input signals were to move beyond this range, erroneous transitioning might incur in the comparator output signal.

With the LM139 comparator, for example, an output signal such as shown in Fig. 2C will result if the output of the tachometer 12 is directly applied to the inverting input 22 of the comparator 16. As can be seen in Fig. 2C, the output signal remains correctly low as long as the tachometer output is above ground, and correctly switches to a high logic level as soon as the tachometer output signal reaches a ground potential. As the tachometer output signal continues to swing negative and drops below approximately -.3 volts, however, parasitic action between the two comparator inputs 22 and 24 causes the output to revert back to a low logic level, where it remains until the tachometer output signal again approaches a ground potential. Because of the reversion to a low logic level, the comparator 16 incorrectly provides two output pulses for each cycle of the tachometer output signal.

To eliminate the erroneous switching, the zero crossing detector 10 includes a protection circuit 28 which is connected between the output 30 of the tachometer 12 and the inverting input 22 of the comparator 16. The purpose of the input protection circuit 28 is to eliminate the negative-going lobes of the tachometer output signal, thereby preventing the parasitic action which would otherwise cause erroneous switching of the comparator circuit 16.

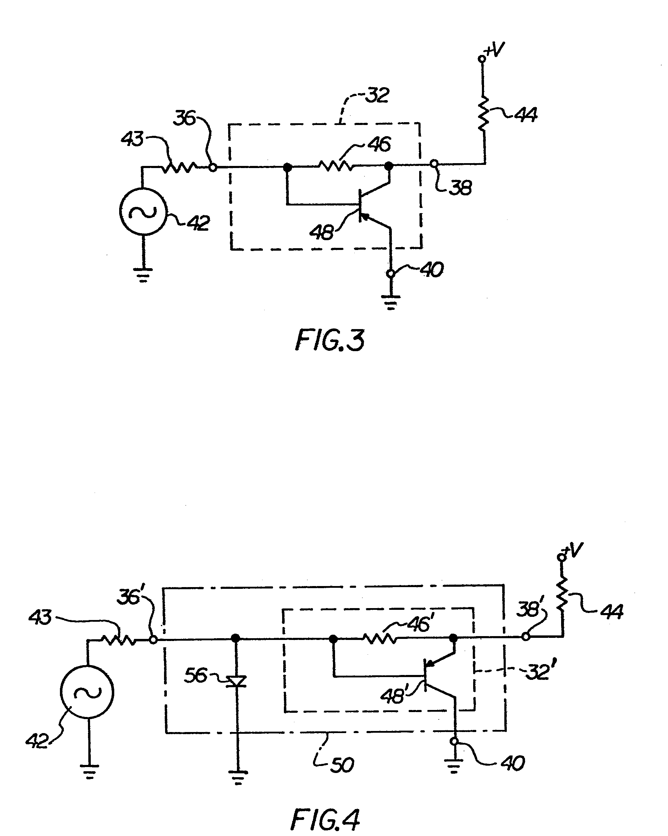

One form which the input protection circuit 28 may take in accordance with the teachings of the present invention is shown in Fig. 3. The input protection circuit 28 of Fig. 3 comprises a clipper circuit 32 which includes an input terminal 36, an output terminal 38, and a reference voltage terminal 40. The input terminal 36 will be connected to an input device (such as tachometer 12), modeled in Fig. 3 as a signal source 42 connected in series with a resistor 43. The output terminal 38, on the other hand, will be connected to an output device (such as signal processor 14), characterized in Fig. 3 as a resistor 44 connecting the terminal 38 to a +V supply. Since the output device will normally represent a high impedance, the resistor 44 should be thought of as having a quite high resistance value. The reference terminal 40 will be connected to a reference voltage corresponding to the voltage at which the clipping action is to take place. In Fig. 3 the reference terminal 40 is shown connected to a ground potential.

The clipper circuit 32 includes two elements: an impedance 46 connected between the input terminal 36 and output terminal 38, and a bipolar junction transistor (BJT) 48 having its collector/emitter current path connected between the output terminal 38 and the reference terminal 40, and its base electrode connected to the input terminal 36. In Fig. 3 the impedance 46 takes the form of a resistor, and the transistor 48 is shown as a conventional PNP transistor having its emitter electrode connected to the reference terminal 40 and its collector electrode connected to the output terminal 38.

When the input signal applied to the input terminal 36 by signal source 42 is at or above the reference potential applied to reference terminal 40, the base-emitter junction of transistor 48 is reverse biased. The base-collector junction of transistor 48, on the other hand, is virtually unbiased, meaning that the base and collector potentials are essentially equal. The base (terminal 36) and collector (terminal 38) potentials are approximately the same because resistor 46 is very small compared to the load impedance 44 whereby there is almost no voltage drop across it. In this circumstance, essentially no current flows through the transistor 48 and it therefore has no effect upon the input signal applied to the input terminal 36. The input signal, unmodified, thus appears at the output terminal 38.

When the input signal drops below ground potential, however, the base-emitter junction of transistor 48 becomes forward biased, whereby base current flows through the transistor. As the input signal generated by source 42 becomes more and more negative, the voltage on terminals 36 remains fixed at -.5 to -.7 volts since the voltage across the base-emitter junction is almost constant.

A transistor is essentially a current amplifier. During linear operation, the level of collector current is equal to some fixed gain factor times the level of base current. Consequently, the flow of base current in transistor 48 causes a larger collector current to be created. Since transistor 48 is a PNP transistor, the direction of the current is from emitter (ground, in this case) to collector. The collector current passes through the resistor 46, causing the collector voltage to rise. The collector voltage can only rise about .5 volts, however, before the collector base junction of transistor 48 becomes forward biased, precluding further collector current increases. This condition, where both the collector-base and base-emitter junctions are forward biased, is referred to as saturation. When a transistor is saturated, increases in base current no longer produce corresponding changes in collector current.

Typical collector-emitter saturation voltages are on the order of .2 volts. Since the voltage at the emitter of the transistor 48 is fixed at ground potential, and since the voltage drop across the collector-emitter current path of the transistor 48 is fixed at the saturation voltage, it follows that the voltage at the collector of the transistor 48 will not drop below approximately -.2 volts. The transistor will remain in saturation as long as base current exists, which in turn will continue as long as the input voltage is negative.

Thus, clipper circuit 28 shown in Fig. 3 passes positive signals without change, but clips negative signals off at ground potential. When the tachometer output signal (Fig. 2A) is applied to its input, the waveform of Fig. 2D results. The waveform lacks a negative lobe and can therefore be applied to comparator 16 without creating incorrect triggering of the comparator.

For ease of understanding, the Fig. 3 circuitry shows the transistor connected for operation in its "normal" mode, where base-emitter current induces collector-emitter current. In this arrangement, the emitter of the transistor 48 is connected to the reference terminal and the collector is connected to the output terminal. It is presently preferred, however, that the collector and emitter connections be reversed. A transistor is a bilateral device, in the sense that the emitter and collectors for most transistors may be reversed, without precluding transistor operation. When operated in an "inverse" mode (i.e., conventional transistor and collector connections reversed), it is base-collector current which induces emitter-collector current. The transistor is characterized by a lower gain factor, and a correspondingly lower saturation voltage (e.g., .1 volt). The reduced saturation voltage attendant with operation of the transistor in the inverse mode is desirable in the present application. Hence it is desirable that the collector and emitter connections be the opposite of that shown in Fig. 3. When connected in the desired fashion, the maximum negative excursion of the signal at the output terminal 38 is approximately .1 volts or lower. The operation of the circuit is otherwise the same as that described above.

The input protection circuit 28 may include more than the single clipper circuit 32. The input protection circuit may, for example, also include a second clipper circuit connected in parallel with the clipper circuit 32 shown in Fig. 3 for the purpose of clipping undesirably high amplitude positive outputs from the tachometer 30. Fig. 4 illustrates an input protection circuit 50 including an additional diode 56 which functions as a second clipper circuit.

The input protection circuit 50 includes a clipper circuit 32' which is substantially the same as the clipper circuit 32 of Fig. 3, but which has the collector and emitter connections of the transistor 48 reversed. The output terminal 38' of the clipper circuit 32' corresponds with the output of the input protection circuit 50, and the input terminal 36' corresponds with the input of the circuit 50. The added diode 56 has its anode connected to the input terminal 36' and its cathode connected to ground.

The diode 56 eliminates that portion of the input signal which is greater than one diode offset (approximately .5 volts) in magnitude. For voltages below this magnitude, the diode 56 is reverse biased, and therefore has no effect upon the operation of the circuit. For voltages above one diode offset, however, the diode 56 is forward biased whereby it becomes conductive and prevents further increases in the input voltage. Consequently, when the signal source is the tachometer 12, the diode 56 clips the upper portion from each positive half cycle of the tachometer output signal. The signal on the output terminal 38' thus has the form shown in Fig. 2E, since the positive half cycles are truncated by diode 56 and the negative half cycles are clipped off by clipper circuit 32'.

In the embodiments described above, the clipping circuit established a minimum signal level. In other words, the circuit clipped off that portion of the input signal which was below the clipping boundary, whereby the clipping boundary was the minimum level that the input signal was permitted to reach. Although the clipping boundary was set at ground potential in the described embodiments, any other clipping boundary can be used by merely connecting the reference terminal to a suitable reference voltage source. For example, if +2 volts is the desired clipping level, reference terminal 40 of Fig. 3 (40' of Fig. 4) will be connected to a +2 volt source.

Furthermore, the clipping circuit can be changed to establish a maximum (rather than a minimum) signal level by substituting an NPN transistor for the PNP transistor shown in Figs. 3 and 4. The circuit will then clip off that portion of the input signal which is above the clipping boundary, whereby the clipping boundary is the maximum level that the input signal is permitted to reach. Again, the clipping boundary will correspond with the reference voltage applied to terminal 40 of Fig. 3 (40' of Fig. 4).

Although the invention has been described with respect to a preferred embodiment, it will be apreciated that various rearrangements and alterations of parts may be made without departing from the spirit and scope of the invention, as defined in the appended claims.

What is claimed is:

1.    Apparatus for clipping a signal at a reference voltage level, comprising:

an input terminal upon which an input voltage is to be applied;

an output terminal;

a reference terminal to which a reference voltage is to be applied;

an impedance connected between said input and output terminals; and

a bipolar junction transistor having its base connected to said input terminal and its collector/emitter current path connected between said output terminal and said reference terminal such that input voltage levels on one side of the level of said reference voltage cause said transistor to turn on and saturate, clipping the voltage at said output terminal at said reference voltage level.

2.    Apparatus as set forth in claim 1, wherein said impedance comprises a resistor.

3.    Apparatus as set forth in claim 1, wherein said bipolar junction transistor has its collector connected to said output terminal and its emitter connected to said reference terminal.

4. Apparatus as set forth in claim 1, wherein said bipolar junction transistor has its emitter connected to said output terminal and its collector connected to said reference terminal.

5. Apparatus as set forth in claim 1, wherein said bipolar junction transistor is a PNP transistor.

6. Apparatus as set forth in claim 1, wherein said bipolar junction transistor is an NPN transistor.

7. Apparatus as set forth in claim 1, and further comprising means for connecting said reference terminal to ground potential, whereby said voltage at said output terminal is clipped substantially at ground potential.

8. Apparatus comprising:
       means for providing an input signal on a first terminal;
       circuit means for processing said input signal, said circuit means having at least one signal input terminal and first and second power supply terminals;
       means for providing a power supply voltage across said first and second power supply terminals; and

circuit protection means connected between said first terminal and said signal input terminal for preventing said input signal from going beyond the voltage on a selected one of said first and second power supply terminals, said circuit protection means including an impedance connected between said first terminal and said signal input terminal, and a bipolar junction transistor having its base connected to said first terminal and its collector/emitter current path connected between said signal input terminal and said selected one of said first and second power supply terminals.

9.    Apparatus as set forth in claim 8, wherein said circuit means comprises an integrated circuit.

10.    Apparatus as set forth in claim 9, wherein said integrated circuit is a signal comparator.

11.    Apparatus as set forth in claim 10, wherein said power supply voltage providing means provides a positive DC potential on said first power supply terminal and ground potential on said second power supply terminal, and wherein said transistor is a PNP transistor having its collector/emitter current path connected between said signal input terminal and said second power supply terminal.

12. Apparatus as set forth in claim 11, wherein said transistor has its collector connected to said second power supply terminal and its emitter connected to said signal input terminal.

13. Apparatus as set forth in claim 8, wherein said impedance comprises a resistor.

14. Apparatus as set forth in claim 8, wherein said transistor has its emitter connected to said signal input terminal and its collector connected to said selected one of said first and second power supply terminals.

15. Apparatus as set forth in claim 8, wherein said transistor has its collector connected to said signal input terminal and its emitter connected to said selected one of said first and second power supply terminals.

16. Apparatus as set forth in claim 8, wherein said power supply voltage providing means provides a positive DC potential on said first power supply terminal and ground potential on said second power supply terminal, and wherein said transistor is a PNP transistor having its collector/emitter current path connected between said signal input terminal and said second power supply terminal.

17. Apparatus as set forth in claim 16, wherein said transistor has its collector connected to said second power supply terminal and its emitter connected to said signal input terminal.

FIG.1

FIG.2

0092116

FIG.3

FIG.4

**EUROPEAN SEARCH REPORT**

European Patent Office

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| X | DE-B-1 158 562 (AG BROWN, BOVERI & CIE) * Column 1, lines 1-4; column 1, line 48 - column 2, line 25; figure 1, elements 7, 8 * | 1,2,4, 6 | H 03 K 5/08<br>H 03 K 5/153<br>G 01 P 3/48 |
| A | Patent Abstracts of Japan vol. 3, no. 74, 26 June 1979 page 163E119 & JP-A-54-53853 * Figure, element 4 * | 1,5,7 | |
| A | GB-A-2 052 926 (SONY CORP.)<br><br>* Column 7, lines 18-50; figure 12 * | | |
| A | AU-B- 432 663 (PHILIPS INDUSTRIES LTD.) * Figure 2 * | | TECHNICAL FIELDS SEARCHED (Int. Cl. ³) |
| A | ELEKTRONIK PRAXIS, vol. 7, no. 10, October 1972, page 78 * Figure 4 * | 8 | F 02 P 7/06<br>G 01 D 5/244<br>G 01 P 3/48<br>G 01 R 19/165<br>G 01 R 19/22<br>H 01 L 27/02<br>H 02 H 7/20<br>H 02 M 7/217<br>H 03 G 11/00<br>H 03 K 3/023<br>H 03 K 5/01<br>H 03 K 5/08<br>H 03 K 5/153<br>H 03 K 5/156<br>H 03 K 5/24<br>H 03 K 12/00<br>H 03 K 17/13 |

The present search report has been drawn up for all claims

| Place of search | Date of completion of the search | Examiner |
|---|---|---|
| BERLIN | 14-06-1983 | ARENDT M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03.82